# EUROPEAN PATENT APPLICATION

(11) **EP 4 458 889 A1**
(43) Date of publication of application: **06.11.2024**
(21) Application number: 22912846.7
(22) Date of filing: 07.01.2022
(51) Int. Cl.: C08J 7/04, C09D 7/41, C23C 14/24

(54) **WHITE-LIGHT-TRANSMITTING COMPOSITE FILM LAYER, PREPARATION METHOD THEREFOR AND USE THEREOF**

(30) Priority: 28.12.2021 CN 202111621728
(71) Applicant: Ningbo Shintai Machines Co., Ltd., Ningbo, Zhejiang 315800 (CN)
(72) Inventor: ZUO, Jianqiu, Ningbo, Zhejiang 315800 (CN); YANG, Xiaofeng, Ningbo, Zhejiang 315800 (CN); FU, Xianglin, Ningbo, Zhejiang 315800 (CN); LUO, Lin, Ningbo, Zhejiang 315800 (CN); YE, Guoqiang, Ningbo, Zhejiang 315800 (CN)
(74) Representative: Elzaburu S.L.P.
(86) International application number: PCT/CN2022/070769
(87) International publication number: WO 2023/123537

(57) **Abstract**

A white-light-transmitting composite film layer is provided with a medium layer and an indium coating, wherein the medium layer is closer to a white light source than the indium coating. The medium layer is a transparent coating containing 0.5-8% of a blue pigment and 0-2% of a purple pigment; or the medium layer is a transparent plastic film containing 0.5-8% of a blue pigment and 0-2% of a purple pigment. The white-light-transmitting composite film layer utilizes the principle of complementary colors in chromatics, and the special medium layer is attached to one side of the indium coating, so that the composite film layer can realize white light transmission, and the color temperature value of transmitted white light is 5200-7200 K.

## Description

### Technical Field

The invention belongs to the technical field of luminescence, and relates to a white-light-transmitting composite film layer, a preparation method therefor and a use thereof.

### Description of Related Art

With the development of the automotive industry towards energy conservation, environmental protection and intelligence, vehicle-mounted luminous wave-transmitting products, such as luminous grilles, luminous signs and luminous interior and exterior trims, will become increasingly popular, wherein the luminous grilles and luminous signs are required to transmit white light, and some of the luminous products are integrated with radar to assist in driving. Existing products capable of transmitting white light are formed by a transparent product sprayed with white paint of a certain thickness and a backlight base plate capable of transmitting white light. When a light is turned on, the product transmits white light seen from the front. However, when the light is turned off, the light-transmitting area of the product only shows an ordinary white color, lacks the high-end metal-plated silver texture and cannot satisfy the appearance requirement of high-end luminous products. By means of the physical vapor deposition (PVD) indium plating process, the light-transmitting area of the product can show a good metal sliver texture seen from the front when the light is turned off. However, when the product is used together with a backlight base plate capable of transmitting white light, the transmitted light is yellow obviously, and the color temperature of the transmitted light is lower than 4500 K, thus failing to satisfy the requirements for white light transmission of products and the color temperature of 5200-7200K of transmitted light. No matter how to adjust the thickness of a PVD indium coating, the vacuum degree of plating, the position of an evaporation source (tungsten filaments), the number of the tungsten filaments, and parameters of evaporation plating, the PVD indium coating cannot transmit white light.

### BRIEF SUMMARY OF THE INVENTION

In view of the defects in the prior art, the invention attaches a special medium layer to one side of an indium coating by means of the principle of complementary colors in chromatics, so that a composite film layer can realize white light transmission, and the color temperature value of transmitted white light is 5200-7200 K.

In one aspect, the invention provides a white-light-transmitting composite film layer, comprising a medium layer and an indium coating, wherein the medium layer is closer to a white light source than the indium coating; the medium layer is a transparent coating containing 0.5-8% of a blue pigment and 0-2% of a purple pigment; or the medium layer is a transparent plastic film containing 0.5-8% of a blue pigment and 0-2% of a purple pigment.

Preferably, a CMYK value of the blue pigment is one or more selected from:
C35 M0 Y20 K0, C40 M0 Y10 K0, C60 M0 Y10 K0, C70 M10 Y0 K0, C45 M10 Y10 K0, C30 M0 Y10 K10, C40 M10 Y0 K20, C60 M15 Y0 K30, C75 M30 Y10 K15, C80 M10 Y20 K0, C95 M25 Y45 K0, C100 M50 Y45 K0, C100 M35 Y10 K0, C95 M60 Y0 K0, C100 M80 Y0 K0, and C90 M70 Y0 K0;
a CMYK value of the purple pigment is one or more selected from:
   C55 M85 Y0 K0, C45 M70 Y50 K0, and C60 M95 Y95 K20.

Preferably, an average particle size of the blue pigment and the purple pigment is 0.15-1.5 µm. Preferably, the white-light-transmitting composite film layer further comprises a transparent panel, and the indium coating is located on any one side of the transparent panel.

Preferably, the white-light-transmitting composite film layer sequentially comprises the medium layer, the indium coating, a transparent priming layer and the transparent panel.

Preferably, a thickness of the medium layer, a thickness of the indium coating, a thickness of the transparent priming layer and a thickness of the transparent panel are 5-35 µm, 15-50 nm, 15-30 µm and 1-10 mm respectively.

Preferably, the white-light-transmitting composite film layer sequentially comprises the medium layer, the indium coating and the transparent panel.

Preferably, a thickness of the medium layer, a thickness of the indium coating and a thickness of the transparent panel are 5-35 µm, 15-50 nm and 1-10 mm respectively.

Preferably, the white-light-transmitting composite film layer sequentially comprises the medium layer, the transparent panel, a transparent priming layer, the indium coating and a transparent coating layer.

Preferably, a thickness of the medium layer, a thickness of the transparent panel, a thickness of the transparent priming layer, a thickness of the indium coating and a thickness of the transparent coating layer are 5-35 µm, 1-10 mm, 15-30 µm, 15-50 nm and 15-30 µm respectively.

Preferably, the white-light-transmitting composite film layer sequentially comprises the transparent panel, the medium layer, the indium coating and a transparent coating layer. Preferably, a thickness of the transparent panel, a thickness of the medium layer, a thickness of the indium coating and a thickness of the transparent coating layer are 1-10 mm, 5-35 µm, 15-50 nm and 15-30 µm respectively.

Preferably, when the white light source illuminates the white-light-transmitting composite film layer, color coordinates of transmitted light are within a range defined by six color coordinate lines:
A (0.310, 0.348), B (0.453, 0.440), C (0.500, 0.440), D (0.500, 0.382), E (0.443, 0.382), and F (0.310, 0.283),
and a color temperature value of the transmitted light is 5200-7200 K.

Preferably, when the white light source illuminates white-light-transmitting composite film layer, color coordinates of transmitted light are within a range defined by six color coordinate lines:
A (0.310, 0.348), B (0.453, 0.440), C (0.500, 0.440), D (0.500, 0.382), E (0.443, 0.382), and F (0.310, 0.283),
and a color temperature value of the transmitted light is 5500-7000 K.

In another aspect, the invention provides a preparation method for the white-light-transmitting composite film layer, wherein in a case where a medium layer is a transparent coating containing 0.5-8% of a blue pigment and 0-2% of a purple pigment, the preparation method comprises the following steps:
performing injection moulding on transparent plastics to form a transparent panel;
coating a side of the transparent panel with a transparent priming paste to form a transparent priming layer;
forming an indium coating on the transparent priming layer by PVD evaporation indium plating; and
coating the indium coating with the transparent coating containing 0.5-8% of the blue pigment and 0-2% of the purple pigment to form the medium layer, thus obtaining the white-light-transmitting composite film layer; or
in a case where a medium layer is a transparent plastic film containing 0.5-8% of a blue pigment and 0-2% of a purple pigment, the preparation method comprises the following steps: performing injection moulding on transparent plastics to form a transparent panel;
coating a side of the transparent panel with a transparent priming paste to form a transparent priming layer;
forming an indium coating on the transparent priming layer by PVD evaporation indium plating; and
attaching the transparent plastic film containing 0.5-8% of the blue pigment and 0-2% of the purple pigment to the indium coating to form the medium layer, thus obtaining the white-light-transmitting composite film layer.

In a third aspect, the invention provides a luminous device, comprising a white light source and the white-light-transmitting composite film layer wherein the medium layer in the white-light-transmitting composite film layer is closer to the white light source than the indium coating, and after white light emitted by the white light source passes through the white-light-transmitting composite film layer, color coordinates of transmitted light are within a range defined by six color coordinate lines: A (0.310, 0.348), B (0.453, 0.440), C (0.500, 0.440), D (0.500, 0.382), E (0.443, 0.382), and F (0.310, 0.283), and a color temperature value of the transmitted light is 5200-7200 K.

The luminous device, for example, may be a vehicle-mounted luminous grille, a luminous sign, a luminous trim, or the like.

Compared with the prior art, the invention has the following beneficial effects:
1. In the invention, the medium layer which is a transparent coating containing a blue pigment and a purple pigment or the medium layer which is a transparent plastic film containing a blue pigment and a purple pigment is added to the back side of the indium coating, so that the composite film layer can realize white light transmission, and the color temperature can reach 5200-7200 K;
2. In the invention, the medium layer is located on the back side of the indium coating, and in a case where a white light source is not turned on, observers can still see the metal texture of a light-transmitting area of the composite film layer from the front, so that the white-light-transmitting composite film layer provided by the invention not only can transmit pure white light, but also can satisfy the requirement for a metal-color appearance;
3. The white-light-transmitting composite film layer provided by the invention can have various structures as long as the medium layer is located on the back side of the indium coating, and the actual structure of the white-light-transmitting composite film layer can be adjusted according to actual product demands;
4. The white-light-transmitting composite film layer provided by the invention can be applied to luminous devices such as vehicle-mounted luminous grilles, luminous signs, luminous interior and exterior trims to ensure that the luminous devices can transmit white light and have a metal-color appearance.

### BRIEF DESCRIPTION OF THE SEVERAL VIEWS OF THE DRAWINGS

FIG. 1 illustrates the range of color coordinates of white light;
FIG. 2 illustrates a first structure of a white-light-transmitting composite film layer according to the invention;
FIG. 3 illustrates a second structure of the white-light-transmitting composite film layer according to the invention;
FIG. 4 illustrates a third structure of the white-light-transmitting composite film layer according to the invention;
FIG. 5 illustrates a fourth structure of the white-light-transmitting composite film layer according to the invention;
FIG. 6 is a schematic structural view of a luminous device according to the invention;

In the FIGS.: 1, transparent panel; 2, transparent priming layer; 3, indium coating; 4, medium layer; 5, transparent coating layer; 6, white light source.

### DETAILED DESCRIPTION OF THE INVENTION

Embodiments of a white-light-transmitting composite film layer and a preparation method therefor provided by the invention are described in detail below. These embodiments are illustrative, and the contents disclosed by the invention are not limited to these embodiments. Drawings used here are merely for better explaining the contents disclosed by the invention and are not intended to limit the protection scope of the invention.

A transparent or semitransparent object can transmit light, wherein part of the light irradiated onto the transparent or semitransparent object is absorbed by the object, and the other part of the light passes through the object. The part of light absorbed by the object cannot be seen, while the part of light passes through the object can be seen by human eyes. Different objects can transmit light in different colors, so the color of transparent objects is determined by light passing through the objects. The primary cause of a yellow color of transmitted light is the structural characteristics of a PVD indium plating film.

Based on the above principle, in the invention, a medium layer in a specific color is arranged on the back side of an indium coating (the back side of the indium coating is defined as a side, close to a white light source, of the indium coating), so that the problem of a yellow color caused by absorption of part of light of the indium coating is solved by means of color complementation of the indium coating and the medium layer, and the light color is harmonized to allow a product to transmit white light.

In some embodiments of the invention, the white-light-transmitting composite film layer comprises a medium layer and an indium coating;
the medium layer is a transparent coating containing 0.5-8% of a blue pigment and 0-2% of a purple pigment; or the medium layer is a transparent plastic film containing 0.5-8% of a blue pigment and 0-2% of a purple pigment.

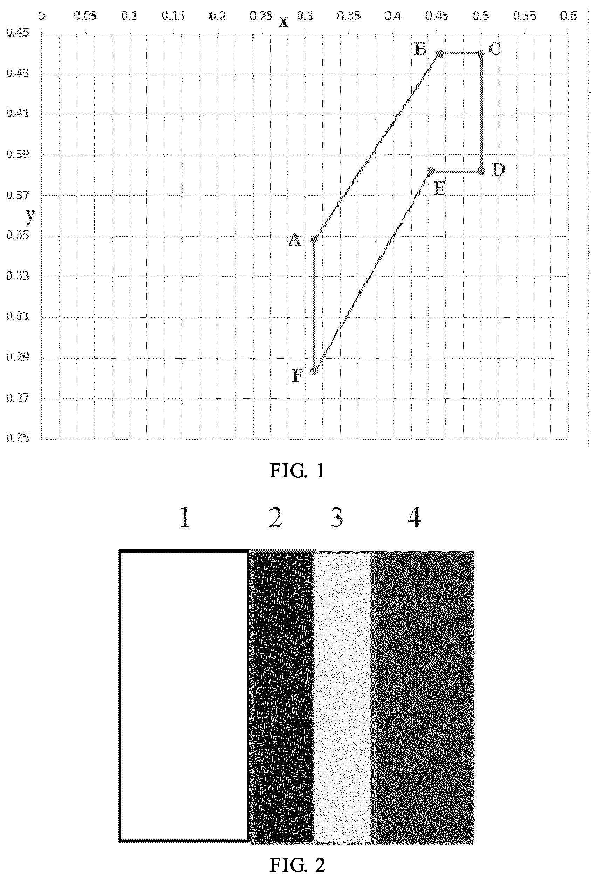

The medium layer in the white-light-transmitting composite film layer is closer to a white light source than the indium coating, white light emitted by the white light source sequentially passes through the medium layer and the indium coating, and after the white light passes through the white-light-transmitting composite film layer, color coordinates of transmitted light are within a range defined by six color coordinate lines:
A (0.310, 0.348), B (0.453, 0.440), C (0.500, 0.440), D (0.500, 0.382), E (0.443, 0.382), and F (0.310, 0.283), as shown in FIG. 1, an area defined by the six coordinate lines is the range of color coordinates of white light;
and a color temperature value of the transmitted light is 5200-7200 K.
a CMYK value of the blue pigment in the medium layer is one or more selected from: C35 M0 Y20 K0, C40 M0 Y10 K0, C60 M0 Y10 K0, C70 M10 Y0 K0, C45 M10 Y10 K0, C30 M0 Y10 K10, C40 M10 Y0 K20, C60 M15 Y0 K30, C75 M30 Y10 K15, C80 M10 Y20 K0, C95 M25 Y45 K0,
C100 M50 Y45 K0, C100 M35 Y10 K0, C95 M60 Y0 K0, C100 M80 Y0 K0, and C90 M70 Y0 K0; a CMYK value of the purple pigment in the medium layer is one or more selected from: C55 M85 Y0 K0, C45 M70 Y50 K0, and C60 M95 Y95 K20.

An average particle size of the blue pigment and the purple pigment is 0.15-1.5 µm.

The specific proportion of the blue pigment and the blue pigment added to the medium layer depends on the selected CMYK value and particle size of the blue pigment and the purple pigment and the thickness of the indium coating.

In some other embodiments of the invention, the white-light-transmitting composite film layer further comprises a transparent panel, and the indium coating is located on any one side of the transparent panel. The indium coating may be next to the transparent panel or spaced from the transparent panel by 1-3 film layers.

In some other embodiments of the invention, the white-light-transmitting composite film layer, as shown in FIG. 2, sequentially comprises a medium layer 4, an indium coating 3, a transparent priming layer 2 and a transparent panel 1, wherein the medium layer 4 is closer to a white light source than the indium coating 3, and white light emitted by the white light source sequentially passes through the medium layer 4, the indium coating 3, the transparent priming layer 2 and the transparent panel 1.

The thickness of the medium layer 4, the thickness of the indium coating 3, the thickness of the transparent priming layer 2 and the thickness of the transparent panel 1 are 5-35 µm, 15-50 nm, 15-30 µm and 1-10 mm respectively.

In a case where a medium layer is a transparent coating containing 0.5-8% of a blue pigment and 0-2% of a purple pigment, the preparation method for the white-light-transmitting composite film layer comprises the following steps:
injection moulding is performed on transparent plastics to form a transparent panel 1;
one side of the transparent panel 1 is coated with a transparent priming paste to form a transparent priming layer 2;
an indium coating 3 is formed on the transparent priming layer 2 by PVD evaporation indium plating; and
the blue pigment and the purple pigment are added to the transparent coating (0.5-8 parts of the blue pigment and 0-2 parts of the purple pigment are added to 100 parts of the transparent coating) and evenly mixed, and then the indium coating 3 is coated with the transparent coating containing the blue pigment and the purple pigment to form the medium layer 4, such that the white-light-transmitting composite film layer is obtained.

The transparent plastics is, for example, polycarbonate, PVC, PET or PP transparent plastics.

Before PVD evaporation indium plating, the transparent panel is coated with a layer of the transparent priming paste, which is a mixture mainly prepared from transparent liquid epoxy resin or acrylic resin, can be used for various coating operations, and can be cross-linked to the transparent panel and the indium coating after being cured, such that the adhesion of the transparent panel and the indium coating is improved, and the metal texture and test performance of the indium coating are improved.

The transparent coating forming the medium layer is a mixture mainly prepared from transparent liquid epoxy resin or acrylic resin, can be used for various coating operations after pigments are added thereto and evenly mixed, and can be cross-linked to upper and lower layers after being cured. The transparent coating and the transparent priming paste comprise the same resin and are different in some additives.

Methods for coating the transparent panel with the transparent priming paste and coating the indium coating with the transparent coating containing the blue pigment and the purple pigment include, but not limited to, spraying, transfer printing, screen printing, curtain coating, painting, and other coating methods.

In a case where a medium layer is a transparent plastic film containing 0.5-8% of a blue pigment and 0-2% of a purple pigment, the preparation method for the white-light-transmitting composite film layer comprises the following steps:
injection moulding is performed on transparent plastics to form a transparent panel 1;
one side of the transparent panel 1 is coated with a transparent priming paste to form a transparent priming layer 2;
an indium coating 3 is formed on the transparent priming layer 2 by PVD evaporation indium plating; and
the blue pigment, the purple pigment and the transparent plastics are evenly mixed (0.5-8 parts of the blue pigment and 0-2 parts of the purple pigment are added to 100 parts of the transparent plastics) and then extruded and rolled to form the transparent plastic film, which is attached to the indium coating 3 to form the medium layer 4, such that the white-light-transmitting composite film layer is obtained.

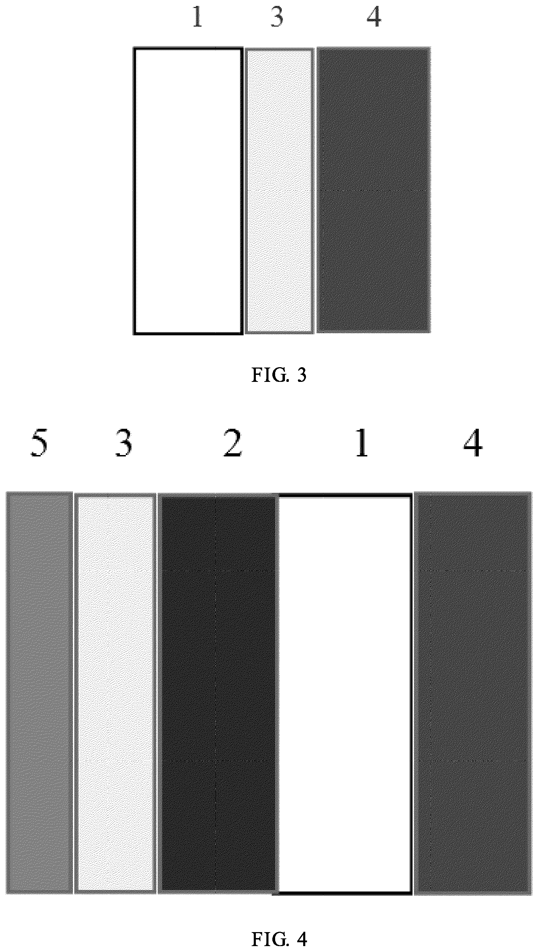

In some other embodiments of the invention, the white-light-transmitting composite film layer, as shown in FIG. 3, sequentially comprises a medium layer 4, an indium coating 3 and a transparent panel 1, wherein the medium layer 4 is closer to a white light source than the indium coating 3, and white light emitted by the white light source sequentially passes through the medium layer 4, the indium coating 3 and the transparent panel 1.

The thickness of the medium layer 4, the thickness of the indium coating 3 and the thickness of the transparent panel 1 are 5-35 µm, 15-50 nm, and 1-10 mm respectively.

The preparation method for the white-light-transmitting composite film layer comprises the following steps:
injection moulding is performed on transparent plastics to form a transparent panel 1;
an indium coating 3 is formed on the transparent panel 1 by PVD evaporation indium plating; and a blue pigment and a purple pigment are added to a transparent coating and evenly mixed, and then the indium coating 3 is coated with transparent coating containing the blue pigment and the purple pigment to form a medium layer 4, such that the white-light-transmitting composite film layer is obtained; or, a blue pigment, a purple pigment and the transparent plastics are evenly mixed and then extruded and rolled to form a transparent plastic film, which is attached to the indium coating 3 to form a medium layer 4.

In some other embodiments of the invention, the white-light-transmitting composite film layer, as shown in FIG. 4, sequentially comprises a medium layer 4, a transparent panel 1, a transparent priming layer 2, an indium coating 3 and a transparent coating layer 5, wherein the medium layer 4 is closer to a white light source than the indium coating 3, and white light emitted by the white light source sequentially passes through the medium layer 4, the transparent panel 1, the transparent priming layer 2, the indium coating 3 and the transparent coating layer 5.

The thickness of the medium layer 4, the thickness of the transparent panel 1, the thickness of the transparent priming layer 2, the thickness of the indium coating 3 and the thickness of the transparent coating layer 5 are 5-35 µm, 1-10 mm, 15-30 µm, 15-50 nm and 15-30 µm respectively.

The preparation method for the white-light-transmitting composite film layer comprises the following steps:
injection moulding is performed on transparent plastics to form a transparent panel 1;
one side of the transparent panel 1 is coated with a transparent priming paste to form a transparent priming layer 2;
an indium coating 3 is formed on the transparent priming layer 2 by PVD evaporation indium plating;
the indium coating 3 is coated with a transparent coating to form a transparent coating layer 5; and
a blue pigment and a purple pigment are added to the transparent coating and evenly mixed, and then the other side of the transparent panel 1 is coated with the transparent coating containing the blue pigment and the purple pigment to form a medium layer 4, such that the white-light-transmitting composite film layer is obtained; or, a blue pigment, a purple pigment and the transparent plastics are evenly mixed and then extruded and rolled to form a transparent plastic film, which is attached to the other side of the transparent panel 1 to form a medium layer 4, such that the white-light-transmitting composite film layer is obtained.

The components of the transparent coating forming the transparent coating layer are the same as those of the transparent coating forming the medium layer. After being dried and cured, the transparent coating layer is cross-linked to a layer in contact with it to protect a wrapping layer inside.

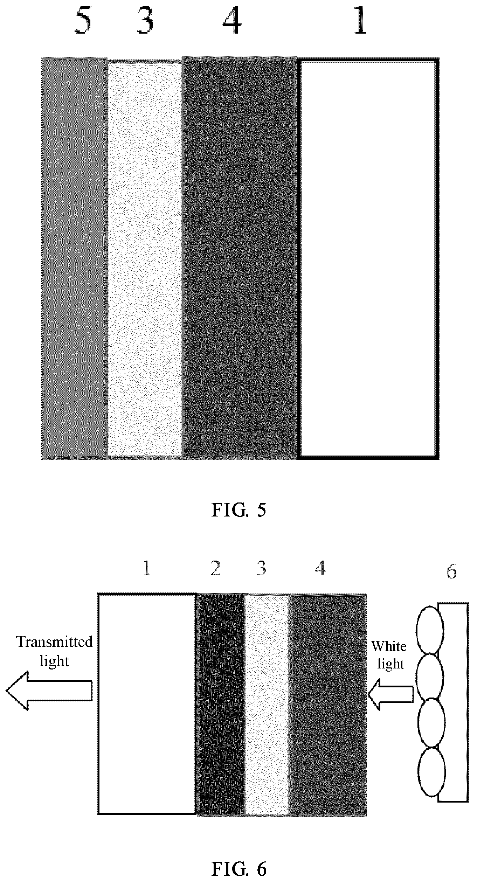

In some other embodiments of the invention, the white-light-transmitting composite film layer, as shown in FIG. 5, sequentially comprises a transparent panel 1, a medium layer 4, an indium coating 3 and a transparent coating layer 5, wherein the medium layer 4 is closer to a white light source than the indium coating 3, and white light emitted by the white light source sequentially passes through the transparent panel 1, the medium layer 4, the indium coating 3 and the transparent coating layer 5.

The thickness of the transparent panel 1, the thickness of the medium layer 4, the thickness of the indium coating 3 and the thickness of the transparent coating layer 5 are 1-10 mm, 5-35 µm, 15-50 nm and 15-30 µm respectively.

The preparation method for the white-light-transmitting composite film layer comprises the following steps:
injection moulding is performed on transparent plastics to form a transparent panel 1;
a blue pigment and a purple pigment are added to a transparent coating and evenly mixed, and then one side of the transparent panel 1 is coated with the transparent coating containing the blue pigment and the purple pigment to form a medium layer 4; or, a blue pigment, a purple pigment and the transparent plastics are evenly mixed and then extruded and rolled to form a transparent plastic film, which is attached to one side of the transparent panel 1 to form a medium layer 4;
an indium coating 3 is formed on the medium layer 4 by PVD evaporation indium plating; and the indium coating 3 is coated with the transparent coating to form a transparent coating layer 5, such that the white-light-transmitting composite film layer is obtained.

In some other embodiments of the invention, a luminous device is provided, comprising a white light source and the white-light-transmitting composite film layer. For example, in a case where the white-light-transmitting composite film layer sequentially comprises a medium layer, an indium coating, a transparent priming layer and a transparent panel, the luminous device, as shown in FIG. 6, comprises a white light source 6, the medium layer 4, the indium coating 3, the transparent priming layer 2 and the transparent panel 1, white light emitted by the white light source 6 sequentially passes through the medium layer 4, the indium coating 3, the transparent priming layer 2 and the transparent panel 1, and color coordinates of transmitted light are within a range defined by six color coordinate lines: A (0.310, 0.348), B (0.453, 0.440), C (0.500, 0.440), D (0.500, 0.382), E (0.443, 0.382), and F (0.310, 0.283),
and a color temperature value of the transmitted light is 5200-7200 K.

The technical solutions of the invention are described in further detail below with reference to specific embodiments. It should be understood that the specific embodiments described here are merely used to help understand the invention and should not be construed as specific limitations of the invention. Unless otherwise specifically stated, raw materials in the embodiments of the invention are all common raw materials in the art, and methods adopted in the embodiments are all conventional methods in the art.

In the following embodiments, the transparent priming paste is VB3390U produced by Fujikura in Japan, and transparent coating is VT3391U produced by Fujikura in Japan.

### Embodiment 1

In this embodiment, the preparation method for the white-light-transmitting composite film layer specifically comprises the following steps:
injection moulding was performed on transparent polycarbonate plastics to form a transparent panel with a thickness of 5 mm;
a transparent priming paste was sprayed onto one side of the transparent panel and cured to form a transparent priming layer with a thickness of 20 µm;
a PVD indium coating with a thickness of 20 nm was formed on the transparent priming layer by PVD evaporation indium plating; and
2 parts of a light sky blue pigment with a CMYK value of C40 M0 Y10 K0 (an average particle size of 300 nm) and 0.5 parts of a pure purple pigment with a CMYK value of C55 M85 Y0 K0 (an average particle size of 300 nm) were added to 100 parts of a transparent coating and evenly mixed, and then the transparent coating containing the light sky blue pigment and the pure purple pigment was sprayed onto the PVD indium coating and cured to form a medium layer with a thickness of 15 µm, such that the white-light-transmitting composite film layer was obtained.

### Embodiment 2

In this embodiment, the preparation method for the white-light-transmitting composite film layer specifically comprises the following steps:
injection moulding was performed on transparent polycarbonate plastics to form a transparent panel with a thickness of 6 mm;
a PVD indium coating with a thickness of 25 nm was formed on the transparent panel by PVD evaporation indium plating; and
3 parts of a water blue pigment with a CMYK value of C60 M0 Y10 K0 (an average particle size of 200 nm), 0.6 parts of a dark reddish purple pigment with a CMYK value of C45 M70 Y50 K0 (an average particle size of 400 nm) and 100 parts of the transparent polycarbonate plastics were evenly mixed and then extruded and rolled to form a transparent plastic film, which was attached to the PVD indium coating to form a medium layer with a thickness of 18 µm, such that the white-light-transmitting composite film layer was obtained.

### Embodiment 3

In this embodiment, the preparation method for the white-light-transmitting composite film layer specifically comprises the following steps:
injection moulding was performed on transparent polycarbonate plastics to form a transparent panel with a thickness of 4 mm;
a transparent priming paste was sprayed onto one side of the transparent panel and cured to form a transparent priming layer with a thickness of 15 µm;
a PVD indium coating with a thickness of 30 nm was formed on the transparent priming layer by PVD evaporation indium plating;
a transparent coating was sprayed onto the PVD indium coating and cured to form a transparent coating layer with a thickness of 20 µm; and
3.5 parts of a cobalt blue pigment with a CMYK value of C95 M60 Y0 K0 (an average particle size of 300 nm) were added to 100 parts of the transparent coating and evenly mixed, and then the transparent coating containing the cobalt blue pigment was sprayed onto the other side of the transparent panel and cured to form a medium layer with a thickness of 20 µm, such that the white-light-transmitting composite film layer was obtained.

### Embodiment 4

In this embodiment, the preparation method for the white-light-transmitting composite film layer specifically comprises the following steps:
injection moulding was performed on transparent polycarbonate plastics to form a transparent panel with a thickness of 7 mm;
2.3 parts of a sky blue pigment with a CMYK value of C70 M10 Y0 K0 (an average particle size of 500 nm) and 1 part of a dark reddish purple pigment with a CMYK value of C45 M70 Y50 K0 (an average particle size of 400 nm) were added to 100 parts of a transparent coating and evenly mixed, and then the transparent coating containing the sky blue pigment and the dark reddish purple pigment was sprayed onto one side of the transparent panel and cured to form a medium layer with a thickness of 22 µm;
a PVD indium coating with a thickness of 35 nm was formed on the medium layer by PVD evaporation indium plating; and
the transparent coating was sprayed onto the PVD indium coating and cured to form a transparent coating layer with a thickness of 25 µm, such that the white-light-transmitting composite film layer was obtained.

### Comparative Example 1

Comparative Example 1 is different from Embodiment 1 in that the medium layer was not formed in the composite film layer in Comparative Example 1.

The white-light-transmitting composite film layers in Embodiments 1-4 and Comparative Example 1 were illuminated with white light with a color temperature of 6300 K emitted by a white light source, and color coordinate and temperature data of transmitted light were tested by means of an LMK imaging luminance meter. Test results are shown in Table 1.

**Table 1 Color coordinate and temperature data of transmitted light**

| | X (color coordinate) | Y (color coordinate) | T (temperature)/ K | Whether the coordinates are within the color coordinate range of white light | Whether the color temperature is within 5200-7200 K |
|---|---|---|---|---|---|
| Embodiment 1 | 0.3452 | 0.3304 | 6780 | Yes | Yes |
| Embodiment 2 | 0.3585 | 0.3306 | 6557 | Yes | Yes |
| Embodiment 3 | 0.3493 | 0.3344 | 6484 | Yes | Yes |
| Embodiment 4 | 0.3506 | 0.3386 | 6598 | Yes | Yes |
| Comparative Example 1 | 0.3647 | 0.4195 | 3971 | No | No |

### Embodiment 5

The white-light-transmitting composite film layer in Embodiment 1 was combined with a white light source to prepare an automotive luminous device.

In a case where the white light source was not turned on, the automotive luminous device showed a good metal effect as seen by human eyes. In a case where the white light source was turned on, white light passed through the automotive luminous device, and light transmitted by the automotive luminous device was white as seen by human eyes. Color coordinate and temperature data of transmitted light tested by means of an LMK imaging luminance meter indicated that the color coordinates of light transmitted by the automotive luminous device were within the color coordinate range of white light and the color temperature of the light transmitted by the automotive luminous device was within 5200-7200 K.

### Comparative Example 2

The white-light-transmitting composite film layer in Comparative Example 1 was combined with a white light source to prepare an automotive luminous device.

In a case where the white light source was not turned on, the automotive luminous device showed a good metal effect as seen by human eyes. In a case where the white light source was turned on, white light passed through the automotive luminous device, and light transmitted by the automotive luminous device was yellow as seen by human eyes. Color coordinate and temperature data of transmitted light tested by means of an LMK imaging luminance meter indicated that the color coordinates of light transmitted by the automotive luminous device were not within the color coordinate range of white light and the color temperature of the light transmitted by the automotive luminous device was not within 5200-7200 K.

Finally, it should be noted that the specific embodiments described here are merely used to explain the spirit of the invention by way of examples and are not intended to limit implementations of the invention. Those skilled in the art can make various amendments, supplements or similar substitutions to the embodiments described here, and it is impossible to enumerate all embodiments of the invention. These obvious modifications or transformations derived from the essential spirit of the invention should also fall within the protection scope of the invention, and it is against with the spirit of the invention to interpret these modifications or transformations as any additional limitations.

## Claims

1. A white-light-transmitting composite film layer, comprising a medium layer and an indium coating, wherein the medium layer is closer to a white light source than the indium coating;
the medium layer is a transparent coating containing 0.5-8% of a blue pigment and 0-2% of a purple pigment; or
the medium layer is a transparent plastic film containing 0.5-8% of a blue pigment and 0-2% of a purple pigment.

2. The white-light-transmitting composite film layer according to Claim 1, wherein a CMYK value of the blue pigment is one or more selected from:
C35 M0 Y20 K0, C40 M0 Y10 K0, C60 M0 Y10 K0, C70 M10 Y0 K0, C45 M10 Y10 K0, C30 M0 Y10 K10, C40 M10 Y0 K20, C60 M15 Y0 K30, C75 M30 Y10 K15, C80 M10 Y20 K0, C95 M25 Y45 K0, C100 M50 Y45 K0, C100 M35 Y10 K0, C95 M60 Y0 K0, C100 M80 Y0 K0, and C90 M70 Y0 K0;
a CMYK value of the purple pigment is one or more selected from:
C55 M85 Y0 K0, C45 M70 Y50 K0, and C60 M95 Y95 K20.

3. The white-light-transmitting composite film layer according to Claim 1, wherein an average particle size of the blue pigment and the purple pigment is 0.15-1.5 µm.

4. The white-light-transmitting composite film layer according to Claim 1, wherein the white-light-transmitting composite film layer further comprises a transparent panel, and the indium coating is located on any one side of the transparent panel.

5. The white-light-transmitting composite film layer according to Claim 1 or 4, wherein the white-light-transmitting composite film layer sequentially comprises the medium layer, the indium coating, a transparent priming layer and the transparent panel.

6. The white-light-transmitting composite film layer according to Claim 5, wherein a thickness of the medium layer, a thickness of the indium coating, a thickness of the transparent priming layer and a thickness of the transparent panel are 5-35 µm, 15-50 nm, 15-30 µm and 1-10 mm respectively.

7. The white-light-transmitting composite film layer according to Claim 1 or 4, wherein the white-light-transmitting composite film layer sequentially comprises the medium layer, the indium coating and the transparent panel.

8. The white-light-transmitting composite film layer according to Claim 7, wherein a thickness of the medium layer, a thickness of the indium coating and a thickness of the transparent panel are 5-35 µm, 15-50 nm and 1-10 mm respectively.

9. The white-light-transmitting composite film layer according to Claim 1 or 4, wherein the white-light-transmitting composite film layer sequentially comprises the medium layer, the transparent panel, a transparent priming layer, the indium coating and a transparent coating layer.

10. The white-light-transmitting composite film layer according to Claim 7, wherein a thickness of the medium layer, a thickness of the transparent panel, a thickness of the transparent priming layer, a thickness of the indium coating and a thickness of the transparent coating layer are 5-35 µm, 1-10 mm, 15-30 µm, 15-50 nm and 15-30 µm respectively.

11. The white-light-transmitting composite film layer according to Claim 1 or 4, wherein the white-light-transmitting composite film layer sequentially comprises the transparent panel, the medium layer, the indium coating and a transparent coating layer.

12. The white-light-transmitting composite film layer according to Claim 11, wherein a thickness of the transparent panel, a thickness of the medium layer, a thickness of the indium coating and a thickness of the transparent coating layer are 1-10 mm, 5-35 µm, 15-50 nm and 15-30 µm respectively.

13. The white-light-transmitting composite film layer according to Claim 1, wherein when the white light source illuminates the white-light-transmitting composite film layer, color coordinates of transmitted light are within a range defined by six color coordinate lines:
A (0.310, 0.348), B (0.453, 0.440), C (0.500, 0.440), D (0.500, 0.382), E (0.443, 0.382), and F (0.310, 0.283),
and a color temperature value of the transmitted light is 5200-7200 K.

14. A preparation method for the white-light-transmitting composite film layer according to Claim 5, wherein in a case where a medium layer is a transparent coating containing 0.5-8% of a blue pigment and 0-2% of a purple pigment, the preparation method comprises the following steps:
performing injection moulding on transparent plastics to form a transparent panel;
coating a side of the transparent panel with a transparent priming paste to form a transparent priming layer;
forming an indium coating on the transparent priming layer by PVD evaporation indium plating; and
coating the indium coating with the transparent coating containing 0.5-8% of the blue pigment and 0-2% of the purple pigment to form the medium layer, thus obtaining the white-light-transmitting composite film layer; or
in a case where a medium layer is a transparent plastic film containing 0.5-8% of a blue pigment and 0-2% of a purple pigment, the preparation method comprises the following steps:
performing injection moulding on transparent plastics to form a transparent panel;
coating a side of the transparent panel with a transparent priming paste to form a transparent priming layer;
forming an indium coating on the transparent priming layer by PVD evaporation indium plating; and
attaching the transparent plastic film containing 0.5-8% of the blue pigment and 0-2% of the purple pigment to the indium coating to form the medium layer, thus obtaining the white-light-transmitting composite film layer.

15. A luminous device, comprising a white light source and the white-light-transmitting composite film layer according to Claim 1, wherein the medium layer and an indium coating, wherein the medium layer in the white-light-transmitting composite film layer is closer to the white light source than the indium coating, and after white light emitted by the white light source passes through the white-light-transmitting composite film layer, color coordinates of transmitted light are within a range defined by six color coordinate lines:
A (0.310, 0.348), B (0.453, 0.440), C (0.500, 0.440), D (0.500, 0.382), E (0.443, 0.382), and F (0.310, 0.283),
and a color temperature value of the transmitted light is 5200-7200 K.
